# FASCICULE DE BREVET EUROPEEN

(11) **EP 3 451 074 B1**
(45) Date de publication et mention de la délivrance du brevet: **22.09.2021**
(21) Numéro de dépôt: 18186389.5
(22) Date de dépôt: 30.07.2018
(51) Int. Cl.: G04B 17/04, G04B 17/28, G04B 31/02, B81B 3/00

(54) **PIVOT ISOCHRONE POUR RÉSONATEUR D'HORLOGERIE**
ISOCHRONER UNRUHZAPFEN FÜR UHRRESONATOR
ISOCHRONOUS PIVOT FOR TIMEPIECE RESONATOR

(30) Priorité: 29.08.2017 EP 17188264
(43) Date de publication de la demande: 06.03.2019
(73) Titulaire: The Swatch Group Research and Development Ltd, 2074 Marin (CH)
(72) Inventeur: Di Domenico, Gianni, 2000 Neuchâtel (CH); Léchot, Dominique, 2722 Les Reussilles (CH); Favre, Jérôme, 2000 Neuchâtel (CH); Hinaux, Baptiste, 1005 Lausanne (CH); Born, Jean-Jacques, 1110 Morges (CH); Helfer, Jean-Luc, 2525 Le Landeron (CH); Winkler, Pascal, 2072 St-Blaise (CH)
(74) Mandataire: ICB SA

(56) Documents cités:
- EP-A1- 3 021 174
- EP-A1- 3 206 089
- FR-A- 1 502 775
- US-A1- 2017 227 930

## Description

### Domaine de l'invention

L'invention concerne un pivot isochrone pour résonateur d'horlogerie, à guidage flexible, comportant au moins un couple comportant deux lames flexibles joignant chacune un premier encastrement d'un premier élément à un deuxième encastrement d'un deuxième élément, lesdits premiers encastrements définissant avec lesdits deuxièmes encastrements respectifs deux directions principales de lames, ledit premier élément et ledit deuxième élément étant chacun plus rigide que chacune desdites lames flexibles, et chacun apte à constituer un élément inertiel mobile au sein d'un dit résonateur, et lesdites deux directions principales de lames définissant un axe de pivotement théorique, à leur croisement ou au croisement de leurs projections sur un plan de référence parallèle auxdites deux lames flexibles, chaque dite lame flexible ayant une longueur libre entre ses deux encastrements, et ayant une distance axiale entre ledit axe de pivotement théorique et celui de ses dits deux encastrements qui en est le plus éloigné, et où, pour chaque dite lame flexible, le rapport d'encastrement principal X=D/L entre ladite distance axiale et ladite longueur libre est supérieur à un, et où lesdites deux directions principales de lames définissent avec ledit axe de pivotement théorique un premier angle au sommet α dont la valeur en degrés satisfait la relation f1(X) <a<f2(X), avec f1(X)= 108 + 67/(10X-6), et f2(X)= 113 + 67/(10X-6).

L'invention concerne encore un résonateur comportant un premier élément et un deuxième élément joints par au moins un couple comportant deux lames flexibles que comporte un tel pivot.

L'invention concerne encore un mouvement d'horlogerie comportant au moins un tel résonateur.

L'invention concerne encore une montre comportant au moins un tel mouvement.

### Arrière-plan de l'invention

L'utilisation de guidages flexibles, notamment à lames souples, dans des oscillateurs mécaniques d'horlogerie, est rendue possible par des procédés d'élaboration, tels que « MEMS », «LIGA» ou similaires, de matériaux micro-usinables, tels que le silicium et ses oxydes, qui permettent une fabrication très reproductible de composants qui présentent des caractéristiques élastiques constantes dans le temps et une grande insensibilité aux agents extérieurs tels que température et humidité. Des pivots à guidage flexible, tels que décrits dans les demandes EP 14199039 ou EP16155039 du même déposant, permettent notamment de remplacer le pivot d'un balancier classique, ainsi que le ressort-spiral qui lui est usuellement associé. La suppression des frottements de pivots permet d'augmenter substantiellement le facteur de qualité d'un oscillateur.

Toutefois, les pivots à guidage flexibles sont connus pour avoir une force de rappel élastique non linéaire, et un mouvement parasite de l'axe instantané de rotation.

Les travaux de Wittrick en 1951 ont permis la réduction du déplacement parasite par positionnement du point de croisement des lames aux sept huitièmes de leur longueur. La demande 14199039 du même déposant propose, en combinaison avec cette disposition, le choix d'un angle au sommet particulier entre les lames, pour optimiser la linéarité de la force de rappel élastique, pour rendre le résonateur isochrone.

Un tel pivot comportant deux lames croisées en projection ne peut toutefois pas être gravé en une seule fois en deux dimensions, ce qui complique sa fabrication.

La demande EP3206089 du même déposant SWATCH GROUP RESEARCH & DEVELOPMENT Ltd propose une géométrie 2D réalisable sur un seul niveau de gravure, et qui possède les avantages recherchés de linéarité et de faible déplacement parasite. Elle décrit un mécanisme résonateur d'horlogerie comportant un premier support avec un premier ancrage et un deuxième ancrage auxquels est fixé un mécanisme flexible de guidage en pivotement, qui définit un axe de pivotement virtuel autour duquel pivote de façon rotative une masse pivotante, et qui comporte au moins un pivot flexible RCC antérieur et un pivot flexible RCC postérieur montés en série et tête-bêche l'un par rapport à l'autre autour dudit axe de pivotement virtuel, ledit pivot flexible RCC antérieur comportant, entre ledit premier support et un support rotatif intermédiaire, deux lames flexibles antérieures droites de même longueur antérieure LA entre leurs encastrements, définissant deux directions linéaires antérieures qui se croisent au niveau dudit axe de pivotement virtuel et qui définissent avec ledit axe de pivotement virtuel un angle antérieur, et dont les ancrages respectifs desdites deux lames flexibles antérieures droites les plus éloignés dudit axe de pivotement virtuel sont tous deux à une même distance antérieure DA dudit axe de pivotement virtuel, et ledit pivot flexible RCC postérieur comportant, entre ledit support rotatif intermédiaire, qui comporte un troisième ancrage et un quatrième ancrage, et ladite masse pivotante, deux lames flexibles postérieures droites de même longueur postérieure LP entre leurs encastrements, définissant deux directions linéaires postérieures qui se croisent au niveau dudit axe de pivotement virtuel et qui définissent avec ledit axe de pivotement virtuel un angle postérieur, et dont les ancrages respectifs desdites deux lames flexibles postérieures droites les plus éloignés dudit axe de pivotement virtuel sont tous deux à une même distance postérieure DP dudit axe de pivotement virtuel. Ce mécanisme flexible de guidage en pivotement est plan, en le centre d'inertie de l'ensemble formé par ladite masse pivotante et toute masse inertielle rapportée que porte ladite masse pivotante est sur ledit axe de pivotement virtuel ou dans son voisinage immédiat, et ledit angle antérieur exprimé en degrés est compris entre :
109.5 + 5/[(DA/LA)-(2/3)] et 114.5 + 5/[(DA/LA)-(2/3)]
et ledit angle postérieur exprimé en degrés est compris entre :
109.5 + 5/[(DP/LP)-(2/3)] et 114.5 + 5/[(DP/LP)-(2/3)].

### Résumé de l'invention

L'invention se propose de définir un résonateur à guidage flexible en rotation, qui soit isochrone, simple à fabriquer, et qui supporte des chocs sans pour autant dégrader un facteur de qualité élevé.

Plus particulièrement il s'agit d'optimiser l'exploitation d'un pivot de type RCC (Remote Compliance Center), avec lames formant un vé, et centre de rotation déporté, facile à fabriquer et robuste, pour remplir ce cahier des charges.

A cet effet, l'invention concerne un pivot isochrone pour résonateur d'horlogerie, à guidage flexible, selon la revendication 1.

L'invention concerne encore un résonateur comportant un premier élément et un deuxième élément joints par au moins un couple comportant deux lames flexibles que comporte un tel pivot, selon la revendication 15.

L'invention concerne encore un mouvement d'horlogerie comportant au moins un tel résonateur.

L'invention concerne encore une montre comportant au moins un tel mouvement.

### Description sommaire des dessins

D'autres caractéristiques et avantages de l'invention apparaîtront à la lecture de la description détaillée qui va suivre, en référence aux dessins annexés, où :
- la figure 1A représente, de façon schématisée, et en vue en plan, les encastrements d'un pivot RCC à deux lames formant un vé, entre une base fixe, et un élément inertiel solide,
- la figure 1B représente, de façon similaire, les longueurs libres L et distances axiales D de ces lames, leur angle au sommet a, et leur point de croisement,
- la figure 2 est un graphe qui représente l'évolution de l'angle au sommet α optimum en ordonnée, en fonction du rapport X=D/L en abscisse, avec une zone d'isochronisme amélioré entre deux courbes, inférieure f1 et supérieure f2, de part et d'autre d'une courbe moyenne fm ,
- la figure 3 représente, de façon similaire à la figure 1, un pivot RCC similaire et comportant un œil autour du point de croisement des lames ,
- la figure 4 représente, en coupe, la zone d'un œil comme celui de la figure 3, qui entoure un noyau pourvu de deux masses d'arrêt faisant antichoc axial de part et d'autre de cet œil ,
- la figure 5 représente, de façon similaire à la figure 4, la configuration inverse avec l'œil muni d'au arbre mobile entre deux lamages inférieur et supérieur d'un élément fixe,
- la figure 6 représente, de façon similaire à la figure 1, la mise en série de deux pivots RCC avec chacun un angle optimum, avec l'élément inertiel comportant un tenon muni d'un œil comme sur la figure 3, et comportant un contour de révolution borné par une chambre d'un élément intermédiaire suspendu à la base fixe par deux lames en sens contraire de celles liant l'élément inertiel à l'élément intermédiaire ,
- la figure 7 représente, de façon similaire à la figure 6, la mise en série de deux pivots RCC avec chacun un angle optimum, avec l'élément inertiel comportant un œil comme sur la figure 3, et comportant un contour de révolution borné par une chambre de la base fixe, à laquelle est suspendu par deux lames en sens contraire un élément intermédiaire faisant cadre et auquel est suspendu l'élément inertiel,
- la figure 8 représente, de façon similaire à la figure 6, la mise en série de deux pivots RCC avec chacun un angle optimum, avec les lames disposées dans le même sens, mais avec deux angles au sommet différents, choisis au-dessus et en-dessous du milieu de la zone d'isochronisme amélioré ,
- la figure 9, analogue à la figure 2, montre le positionnement des deux angles de la figure 8,
- la figure 10 est un schéma-blocs qui représente une montre comportant un mouvement incorporant un résonateur muni d'un tel pivot,

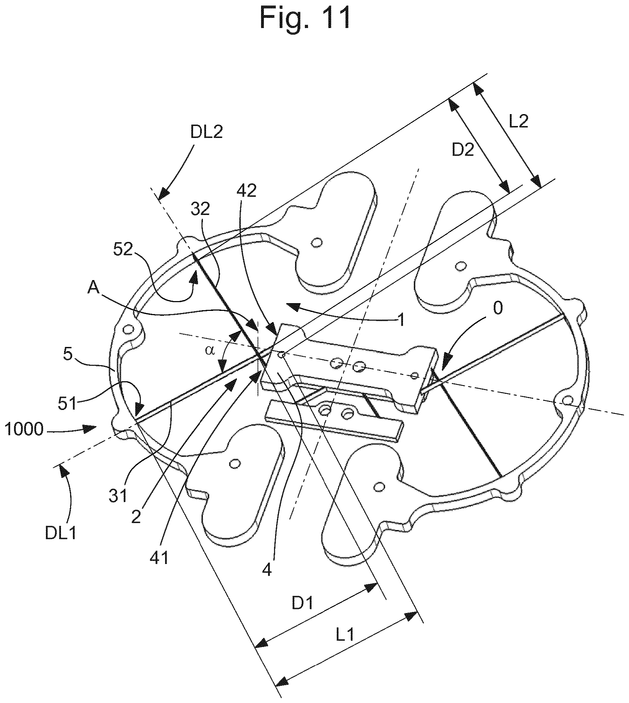

- la figure 11 représente un résonateur qui n'appartient pas à l'objet des revendications annexées.

### Description détaillée des modes de réalisation préférés

L'invention concerne un pivot 1 isochrone pour résonateur 100 d'horlogerie, à guidage flexible, comportant au moins un couple dénommé génériquement 2, ou plus particulièrement un premier couple 21 ou un deuxième couple 22, selon les variantes illustrées par les figures. Ce couple 2 comporte deux lames flexibles 3 : 31, 32, joignant chacune un premier encastrement 41, 42, d'un premier élément 4 à un deuxième encastrement 51, 52, d'un deuxième élément 5. Ces premiers encastrements 41, 42, définissent avec les deuxièmes encastrements 51, 52, respectifs deux directions principales de lames DL1 et DL2. Le premier élément 4 et le deuxième élément 5 sont chacun plus rigide que chacune des lames flexibles 3, et chacun est apte à constituer un élément inertiel mobile au sein d'un résonateur 100.

Les deux directions principales de lames DL1, DL2, définissant un axe de pivotement théorique A, à leur croisement quand les deux lames flexibles 31, 32, sont coplanaires, ou au croisement de leurs projections sur un plan de référence parallèle aux deux lames flexibles 31, 32, quand les deux lames flexibles 31, 32 ,se développent sur deux niveaux parallèles au plan de référence mais ne sont pas coplanaires.

Chaque lame flexible 31, 32, a une longueur dite libre L1, L2, entre ses deux encastrements 41, 51, 42, 52, et ayant une distance axiale D1, D2, entre l'axe de pivotement théorique A et celui de ses deux encastrements 41, 51, 42, 52, qui en est le plus éloigné.

Pour chaque lame flexible 31, 32, le rapport d'encastrement principal D1/L1, D2/L2 entre la distance axiale et la longueur libre est supérieur à un.

L'invention concerne encore un résonateur 100 comportant un premier élément 4 et un deuxième élément 5 joints par au moins un tel couple 2 comportant deux lames flexibles 31, 32, que comporte un tel pivot 1.

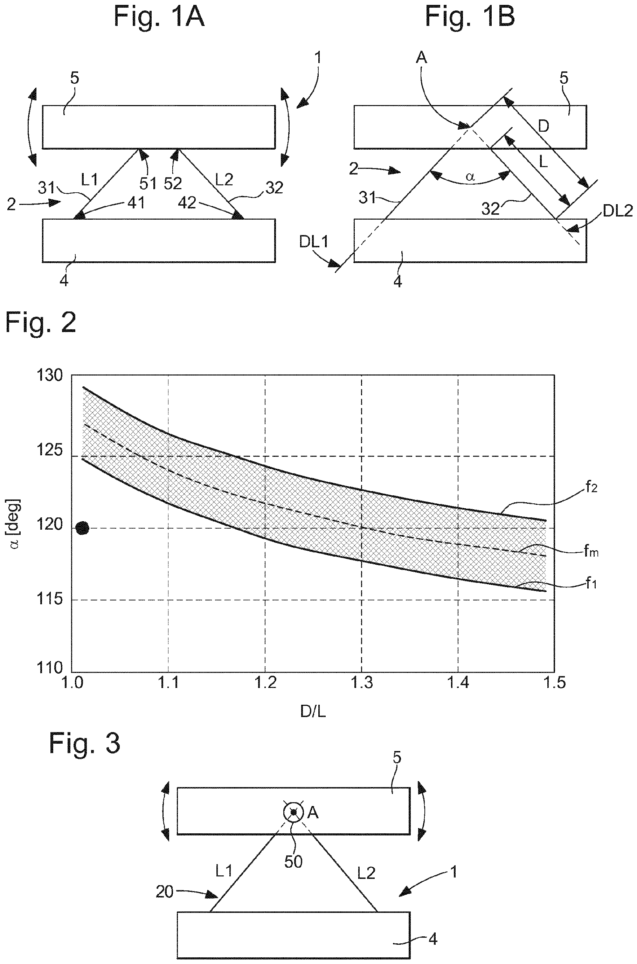

Tel que visible sur la figure 2, les deux directions principales de lames DL1, DL2, définissent avec l'axe de pivotement théorique A le premier angle au sommet a, dont la valeur dépend du rapport d'encastrement principal D1/L1, D2/L2, entre une première fonction inférieure f1 telle que a= f1(D/L), et une première fonction supérieure f2, telle que a= f2(D/L).

Plus particulièrement, f1(X)= 108 + 67/(10X-6), avec X= D/L.

Plus particulièrement, f2(X)= 113 + 67/(10X-6), avec X= D/L.

De façon particulière, D1/L1 = D2/L2 = D/L = X, et est plus grand que 1. La valeur en degrés du premier angle au sommet α satisfait alors la relation f1(D/L) <α<f2(D/L), avec f1(D/L)= 108 + 67/(10X-6), et f2(D/L)= 113 + 67/(10X-6), avec X= D/L.

Plus particulièrement, les deux directions principales de lames DL1 et DL2 définissent avec l'axe de pivotement théorique A un premier angle au sommet a, qui est compris entre 115° et 130°, bornes comprises. Ceci revient à borner la valeur X= D/L entre les valeurs X=1 et X=1.55.

Plus particulièrement, l'axe de pivotement théorique A est situé géométriquement dans le premier élément 4 ou dans le deuxième élément 5.

La figure 3 illustre le cas avantageux où l'axe de pivotement théorique A est situé géométriquement dans le deuxième élément 5.

Plus particulièrement cet axe de pivotement théorique A est situé géométriquement dans une ouverture dite œil 40, 50, que comporte le premier élément 4 ou le deuxième élément 5.

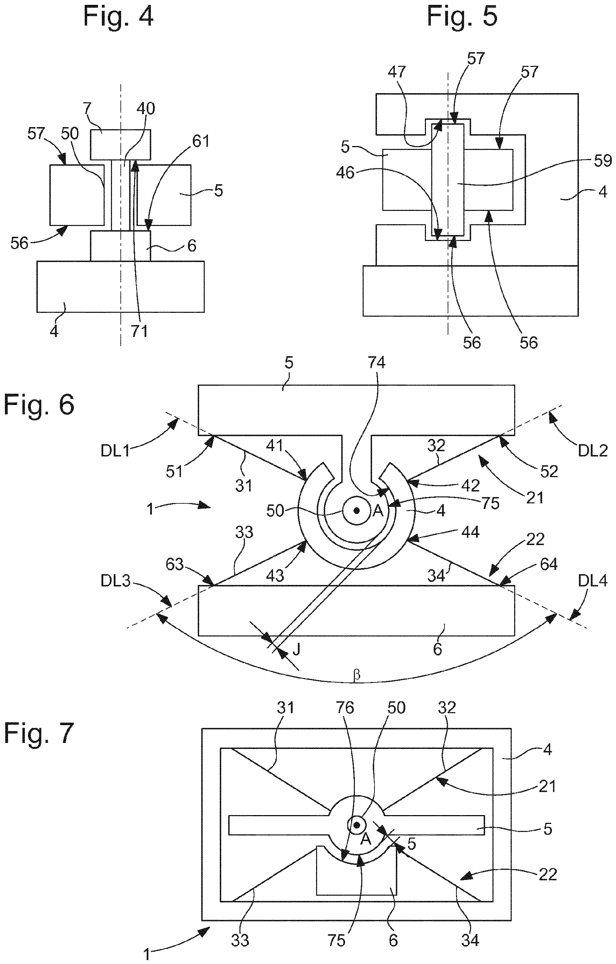

La figure 4 représente, en coupe, la zone d'un œil 50 dans le deuxième élément inertiel 5, qui entoure un noyau 40, ici non limitativement solidaire du premier élément 4 qui constitue une masse fixe, et lequel noyau 40 est pourvu de deux masses d'arrêt 6 et 7 faisant antichoc axial de part et d'autre de cet œil 50 et de l'élément inertiel 5, dont les surfaces inférieure 56 et supérieure 57 sont agencées pour coopérer en limitation de butée avec ces masses d'arrêt 6 et 7. La figure 5 illustre la configuration inverse avec l'œil 50 muni d'un arbre 59 mobile entre deux lamages inférieur 46 et supérieur 47 d'un élément fixe 4, les extrémités 56 et 57 de cet arbre 59 étant agencées pour coopérer en limitation de butée avec ces lamages 46 et 47.

Plus particulièrement, le pivot 1 comporte au moins un couple 2 comportant deux lames flexibles 31, 32, qui sont, ou bien identiques en symétrie par rapport à un plan de symétrie passant par l'axe de pivotement théorique A quand les deux lames flexibles 31, 32, sont coplanaires, ou bien identiques en symétrie en projection sur un plan de référence parallèle aux deux lames flexibles 31, 32, quand les deux lames flexibles 31, 32,se développent sur deux niveaux parallèles au plan de référence mais ne sont pas coplanaires, par rapport à un plan de symétrie passant par l'axe de pivotement théorique A.

Plus particulièrement chaque couple 2, que comporte le pivot 1, comporte deux lames flexibles 31,32, qui sont, ou bien identiques en symétrie par rapport à un plan passant par l'axe de pivotement théorique A quand les deux lames flexibles 31, 32, sont coplanaires, ou bien identiques en symétrie en projection sur un plan de référence parallèle aux deux lames flexibles 31, 32, quand les deux lames flexibles 31, 32, se développent sur deux niveaux parallèles au plan de référence mais ne sont pas coplanaires.

Plus particulièrement le pivot 1 comporte au moins un couple 2 comportant deux lames flexibles 31, 32, qui sont coplanaires.

Plus particulièrement, selon l'invention, le pivot 1 comporte au moins un couple 2 comportant deux lames flexibles 31, 32, qui se développent sur deux niveaux parallèles au plan de référence mais ne sont pas coplanaires.

Plus particulièrement, le pivot 1 est symétrique, au moins en projection sur le plan de référence, par rapport à un plan de symétrie passant par l'axe de pivotement théorique A, et le centre de masse du résonateur 100 dans sa position de repos est situé géométriquement sur le plan de symétrie.

Avantageusement, on positionne le centre de masse du résonateur, dans sa position de repos, sur l'axe de symétrie du pivot, et à une faible distance de l'axe de rotation A défini par le point de croisement des prolongements des lames, ce qui a pour effet de compenser le déplacement parasite du pivot. Pour un pivot simple, la distance optimale dépend du rapport X=D/L. Ainsi le centre de masse du résonateur 100 dans sa position de repos est distant de l'axe de pivotement théorique A d'un écart ε qui dépend des longueurs libres L1, L2, et des rapports d'encastrements D1/L1, D2/L2. Plus particulièrement D1/L1 = D2/L2 = D/L = X. Plus particulièrement encore D1= D2= D et L1=L2= L, et cet écart ε est sensiblement égal à la valeur (2D²/L - 1.6. D - 0.1 L). Plus particulièrement cet écart ε est compris entre 0.8 fois et 1.2 fois la valeur (2D²/L - 1.6. D - 0.1 L).

Les pivots RCC tels que décrits ci-dessus peuvent être combinés de plusieurs façons. En particulier, les figures 6 à 8 illustrent des variantes non limitatives, résultant de différentes combinaisons de couples de lames.

Plus particulièrement le pivot 1 comporte ainsi, en plus d'un premier couple 21 comportant les deux lames flexibles 31, 32, joignant chacune un premier encastrement 41, 42, d'un premier élément 4 à un deuxième encastrement 51, 52, d'un deuxième élément 5, au moins un deuxième couple 22 comportant deux autres lames flexibles 33, 34, joignant chacune, d'une part un encastrement primaire 43, 44, du premier élément 4 ou un encastrement secondaire 53, 54, du deuxième élément 5, à d'autre part un encastrement tertiaire 63, 64, que comporte un troisième élément 6 agencé pour être fixé solidairement à une structure fixe du résonateur 100.

Plus particulièrement le premier élément 4 ou le deuxième élément 5 est un élément inertiel, et l'axe de pivotement théorique A est situé géométriquement dans un œil 40, 50, que comporte cet élément inertiel. Les figures 6 à 8 comportent un tel œil 50 dans l'élément inertiel 5.

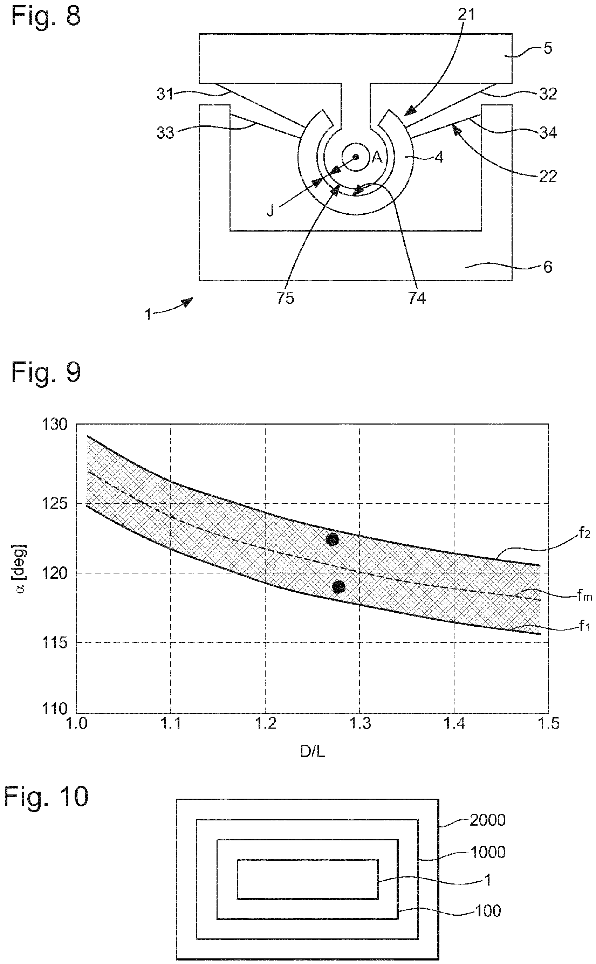

Plus particulièrement, tel que visible sur les figures 6 et 8, le premier élément 4 ou le deuxième élément 5 comporte une surface concave 74 agencée pour entourer à distance, sur au moins 180°, une surface convexe 75 que comporte le deuxième élément 5 ou respectivement le premier élément 4, avec, dans une position de repos du pivot 1, un jeu en tout point supérieur ou égal à un jeu de sécurité J entre la surface convexe 75 et la surface concave 74.

La figure 6 illustre la mise en série de deux pivots RCC avec chacun un angle optimum, avec l'élément inertiel 5 comportant un tenon muni d'un œil 50, et comportant un contour partiellement de révolution 75 borné par une chambre 74 d'un élément intermédiaire 4 suspendu à la base fixe 6 par deux lames 33, 34, en sens contraire de celles 31, 32, liant l'élément inertiel 5 à l'élément intermédiaire 4.

Plus particulièrement, le premier élément 4 ou le deuxième élément 5 est un élément inertiel, et le troisième élément 6, notamment la base fixe, comporte une surface interne 76 agencée pour entourer à distance, sur au moins 180°, une surface convexe 75 que comporte l'élément inertiel, avec, dans une position de repos du pivot 1, un jeu en tout point supérieur ou égal à un jeu de sécurité J entre la surface convexe 75 et la surface interne 76.

La figure 7 concerne la mise en série de deux pivots RCC avec chacun un angle optimum, avec l'élément inertiel 5 comportant un œil 50, et comportant un contour partiellement de révolution 75 borné par une chambre 76 de la base fixe 6, à laquelle est suspendu par deux lames 33, 34, en sens contraire un élément intermédiaire 4 faisant cadre et auquel est suspendu l'élément inertiel 5.

Plus particulièrement, tel que visible sur la figure 8, qui concerne la mise en série de deux pivots RCC avec chacun un angle optimum a, β, différent, avec les lames disposées dans le même sens, mais avec deux angles au sommet différents, choisis au-dessus et en-dessous du milieu de la zone d'isochronisme amélioré : d'une part les encastrements primaires 43, 44, du premier élément 4 ou encastrements secondaires 53, 54, du deuxième élément 5, et d'autre part les encastrements tertiaires 63, 64, définissent deux directions secondaires de lames DL3, DL4, qui forment ensemble un deuxième angle au sommet β au niveau d'un axe secondaire B défini par le croisement, en plan ou en projection, des directions secondaires de lames DL3, DL4. Ce deuxième angle au sommet β est, comme le premier angle au sommet a, compris entre 115° et 130°, bornes comprises, ou bien sa valeur dépend d'un rapport d'encastrement secondaire D3/L3, D4/L4, entre une première fonction inférieure f1 telle que β= f1(D/L), et une première fonction supérieure f2, telle que β= f2(D/L), et, plus particulièrement et tel que visible sur la figure 9, une fonction médiane fm(X)= 110.5 + 67/(10X-6) définit un rapport intermédiaire entre la première fonction inférieure f1(X)= 108 + 67/(10X-6), et la première fonction supérieure f2(X)= 113 + 67/(10X-6), avec X= D/L, et le premier angle au sommet α et le deuxième angle au sommet β sont positionnés entre la première fonction inférieure f1 et la première fonction supérieure f2, de part et d'autre de la fonction médiane fm.

Plus particulièrement l'axe de pivotement théorique A, est confondu avec l'axe secondaire B.

L'invention concerne encore un mouvement d'horlogerie 1000 comportant au moins un tel résonateur 100.

L'invention concerne encore une montre 2000 comportant un tel mouvement d'horlogerie 1000.

## Revendications

1. Pivot (1) isochrone pour résonateur (100) d'horlogerie, à guidage flexible, comportant au moins un couple (2, 21, 22) comportant deux lames flexibles (31 , 32) joignant chacune un premier encastrement (41 , 42) d'un premier élément (4) à un deuxième encastrement (51 , 52) d'un deuxième élément (5), lesdits premiers encastrements (41 ,42) définissant avec lesdits deuxièmes encastrements (51 , 52) respectifs deux directions principales de lames (DL1 , DL2), ledit premier élément (4) et ledit deuxième élément (5) étant chacun plus rigide que chacune desdites lames flexibles (3), et chacun apte à constituer un élément inertiel mobile au sein d'un dit résonateur (100), et lesdites deux directions principales de lames (DL1 , DL2) définissant un axe de pivotement théorique (A), à leur croisement, ou au croisement de leurs projections sur un plan de référence parallèle auxdites deux lames flexibles (31 , 32), chaque dite lame flexible (31 , 32) ayant une longueur libre (L1 , L2) entre ses deux encastrements (41, 51 , 42, 52), et ayant une distance axiale (D1 , D2) entre ledit axe de pivotement théorique (A) et celui de ses dits deux encastrements (41, 51 , 42, 52) qui en est le plus éloigné, et où, pour chaque dite lame flexible (31 , 32), le rapport d'encastrement principal (D1/L1 , D2/L2) entre ladite distance axiale et ladite longueur libre est supérieur à un, où lesdites deux directions principales de lames (DL1 , DL2) définissent avec ledit axe de pivotement théorique (A) un premier angle au sommet (α) dont la valeur en degrés satisfait la relation f1(D/L) <a<f2(D/L), avec f1(X)= 108 + 67/(10X-6), et f2(X)= 113 + 67/(10X-6), avec X= D/L, **caractérisé en ce que** ledit pivot (1) comporte au moins un couple (2, 21, 22) comportant deux lames flexibles (31 , 32) qui se développent sur deux niveaux parallèles audit plan de référence mais ne sont pas coplanaires.

2. Pivot (1) selon la revendication 1, **caractérisé en ce que** lesdites deux directions principales de lames (DL1 , DL2) définissent avec ledit axe de pivotement théorique (A) un premier angle au sommet (α) compris entre 115° et 130°, bornes comprises.

3. Pivot (1) selon la revendication 1 ou 2, **caractérisé en ce que** ledit axe de pivotement théorique (A) est géométriquement situé dans ledit premier élément (4) ou dans ledit deuxième élément (5).

4. Pivot (1) selon la revendication 3, **caractérisé en ce que** ledit axe de pivotement théorique (A) est situé géométriquement dans un œil (40, 50) que comporte ledit premier élément (4) ou ledit deuxième élément (5).

5. Pivot (1) selon l'une des revendications 1 à 4, **caractérisé en ce que** ledit pivot (1) comporte, en plus d'un premier couple (21) comportant lesdites deux lames flexibles (31 , 32) joignant chacune un premier encastrement (41 , 42) d'un premier élément (4) à un deuxième encastrement (51 , 52) d'un deuxième élément (5), au moins un deuxième couple (22) comportant deux autres lames flexibles (33 , 34) joignant chacune, d'une part un encastrement primaire (43 , 44) dudit premier élément (4) ou un encastrement secondaire (53 , 54) dudit deuxième élément (5), à d'autre part un encastrement tertiaire (63 , 64) que comporte un troisième élément (6) agencé pour être fixé solidairement à une structure fixe dudit résonateur (100).

6. Pivot (1) selon les revendications 4 et 5, **caractérisé en ce que** ledit premier élément (4) ou ledit deuxième élément (5) est un élément inertiel, et **en ce que** ledit axe de pivotement théorique (A) est situé géométriquement dans ledit œil (40, 50) que comporte ledit élément inertiel.

7. Pivot (1) selon l'une des revendications 1 à 6, **caractérisé en ce que** ledit premier élément (4) ou ledit deuxième élément (5) comporte une surface concave (74) agencée pour entourer à distance, sur au moins 180°, une surface convexe (75) que comporte ledit deuxième élément (5) ou respectivement ledit premier élément (4), avec, dans une position de repos dudit pivot (1), un jeu en tout point supérieur ou égal à un jeu de sécurité (J) entre ladite surface convexe (75) et ladite surface concave (74).

8. Pivot (1) selon la revendication 5 et l'une des revendications 1 à 7, **caractérisé en ce que** ledit premier élément (4) ou ledit deuxième élément (5) est un élément inertiel, et **en ce que** ledit troisième élément (6) comporte une surface interne (76) agencée pour entourer à distance, sur au moins 180°, une surface convexe (75) que comporte ledit élément inertiel, avec, dans une position de repos dudit pivot (1), un jeu en tout point supérieur ou égal à un jeu de sécurité (J) entre ladite surface convexe (75) et ladite surface interne (76).

9. Pivot (1) selon la revendication 5 ou l'une des revendications qui en dépendent, **caractérisé en ce que** lesdits, d'une part encastrements primaires (43, 44) dudit premier élément (4) ou encastrements secondaires (53 , 54) dudit deuxième élément (5), et d'autre part lesdits encastrements tertiaires (63, 64) définissent deux directions secondaires de lames (DL3, DL4) formant ensemble un deuxième angle au sommet (β) au niveau d'un axe secondaire (B) défini par le croisement, en plan ou en projection, desdites directions secondaires de lames (DL3, DL4), ledit deuxième angle au sommet (β) étant compris entre 115° et 130°, bornes comprises, et dont la valeur en degrés satisfait la relation f1(D/L) <β<f2(D/L), avec f1(X)= 108 + 67/(10X-6), et f2(X)= 113 + 67/(10X-6), avec X= D/L.

10. Pivot (1) selon les revendications 2 et 9, **caractérisé en ce qu'**une fonction médiane fm(X)= 110.5 + 67/(10X-6) définit un rapport intermédiaire entre ladite première fonction inférieure f1(X)= 108 + 67/(10X-6), et ladite première fonction supérieure f2(X)= 113 + 67/(10X-6), avec X= D/L, et **en ce que** ledit premier angle au sommet (α) et ledit deuxième angle au sommet (β) sont positionnés entre ladite première fonction inférieure f1 et ladite première fonction supérieure f2, de part et d'autre de ladite fonction médiane fm.

11. Pivot (1) selon la revendication 9 ou 10, **caractérisé en ce que** lesdits axe de pivotement théorique (A) et axe secondaire (B) sont confondus.

12. Pivot (1) selon l'une des revendications 1 à 11, **caractérisé en ce que** ledit pivot (1) comporte au moins un couple (2, 21, 22) comportant deux lames flexibles (31 , 32) qui sont, ou bien symétriques par rapport à un plan de symétrie passant par ledit axe de pivotement théorique (A) quand lesdites deux lames flexibles (31 , 32) sont coplanaires, ou bien symétriques en projection sur un plan de référence parallèle auxdites deux lames flexibles (31 , 32) quand lesdites deux lames flexibles (31 , 32) se développent sur deux niveaux parallèles audit plan de référence mais ne sont pas coplanaires, par rapport à un plan de symétrie passant par ledit axe de pivotement théorique (A).

13. Pivot (1) selon la revendication 12, **caractérisé en ce que** chaque dit couple (2, 21, 22), que comporte ledit pivot (1), comporte deux lames flexibles (31 , 32) qui sont, ou bien identiques en symétrie par rapport à un plan passant par ledit axe de pivotement théorique (A) quand lesdites deux lames flexibles (31, 32) sont coplanaires, ou bien identiques en symétrie en projection sur un plan de référence parallèle auxdites deux lames flexibles (31 , 32) quand lesdites deux lames flexibles (31 , 32) se développent sur deux niveaux parallèles audit plan de référence mais ne sont pas coplanaires.

14. Pivot (1) selon l'une des revendications 1 à 13, **caractérisé en ce que** ledit pivot (1) comporte au moins un couple (2, 21, 22) comportant deux lames flexibles (31 , 32) qui sont coplanaires.

15. Résonateur (100) comportant un premier élément (4) et un deuxième élément (5) joints par au moins un couple (2, 21, 22) comportant deux lames flexibles (31 , 32) que comporte un pivot (1) selon l'une des revendications 1 à 14, **caractérisé en ce que** le centre de masse dudit résonateur (100) dans sa position de repos est distant dudit axe de pivotement théorique (A) d'un écart (ε) qui est compris entre 0.8 fois et 1.2 fois la valeur (2D²/L - 1.6. D - 0.1 L).

16. Résonateur (100) selon la revendication 15, **caractérisé en ce que** ledit pivot (1) est symétrique, au moins en projection sur ledit plan de référence, par rapport à un plan de symétrie passant par ledit axe de pivotement théorique (A), et **en ce que** ledit centre de masse dudit résonateur (100) dans sa position de repos est situé géométriquement sur ledit plan de symétrie.

17. Mouvement d'horlogerie (1000) comportant au moins un résonateur (100) selon la revendication 15 ou 16.

18. Montre (2000) comportant un mouvement d'horlogerie (1000) selon la revendication 17.

## Patentansprüche

1. Isochroner Drehzapfen (1) für einen Uhrenresonator (100) mit flexibler Führung, umfassend mindestens ein Paar (2, 21, 22) mit zwei flexiblen Lamellen (31, 32), von denen jede ein erstes Lager (41, 42) eines ersten Elements (4) mit einem zweiten Lager (51, 52) eines zweiten Elements (5) verbindet, wobei die ersten Lager (41, 42) mit den entsprechenden zweiten Lagern (51, 52) zwei Lamellen-Primärrichtungen (DL1, DL2) definieren, wobei das erste Element (4) und das zweite Element (5) jeweils steifer als jede der flexiblen Lamellen (3) sind und von denen jedes geeignet ist, ein bewegliches Trägheitselement innerhalb des Resonators (100) zu bilden, wobei die beiden Primärrichtungen (DL1, DL2) der Lamellen an ihrem Schnittpunkt oder am Schnittpunkt ihrer Projektionen auf eine zu den beiden flexiblen Lamellen (31, 32) parallele Bezugsebene eine theoretische Schwenkachse (A) definieren, wobei jede der flexiblen Lamellen (31, 32) eine freie Länge (L1, L2) zwischen ihren beiden Lagern (41, 51, 42, 52) besitzt und einen axialen Abstand (D1, D2) zwischen der theoretischen Schwenkachse (A) und jenem der beiden Lager (41, 51, 42, 52), das hiervon am weitesten entfernt ist, besitzt und wobei für jede flexible Lamelle (31, 32) das Hauptlagerverhältnis (D1/L1, D2/L2) zwischen dem axialen Abstand und der freien Länge größer als eins ist, wobei die beiden Primärrichtungen (DL1, DL2) der Lamellen mit der theoretischen Schwenkachse (A) einen ersten Scheitelwinkel (α) definieren, dessen Wert in Grad die Beziehung f₁(D/L) < α< f₂(D/L) erfüllt, mit f₁(X) = 108 + 67/(10X - 6), und f₂(X) = 113 + 67/(10X - 6) mit X = D/L, **dadurch gekennzeichnet, dass** der Drehzapfen (1) mindestens ein Paar (2, 21, 22) umfasst, das zwei flexible Lamellen (31, 32) aufweist, die sich in zwei Ebenen, die zu der Bezugsebene parallel, jedoch nicht koplanar sind, erstrecken.

2. Drehzapfen (1) nach Anspruch 1, **dadurch gekennzeichnet, dass** die beiden Primärrichtungen (DL1, DL2) der Lamellen mit der theoretischen Schwenkachse (A) einen ersten Scheitelwinkel (α) definieren, der zwischen 115° und 130°, Grenzwerte eingeschlossen, liegt.

3. Drehzapfen (1) nach Anspruch 1 oder 2, **dadurch gekennzeichnet, dass** sich die theoretische Schwenkachse (A) geometrisch in dem ersten Element (4) oder in dem zweiten Element (5) befindet.

4. Drehzapfen (1) nach Anspruch 3, **dadurch gekennzeichnet, dass** sich die theoretische Schwenkachse (A) geometrisch in einem Auge (40, 50) befindet, das das erste Element (4) oder das zweite Element (5) aufweist.

5. Drehzapfen (1) nach einem der Ansprüche 1 bis 4, **dadurch gekennzeichnet, dass** der Drehzapfen (1) zusätzlich zu einem ersten Paar (21), das die beiden flexiblen Lamellen (31, 32) aufweist, die jeweils ein erstes Lager (41, 42) eines ersten Elements (4) mit einem zweiten Lager (51, 52) eines zweiten Elements (5) verbinden, mindestens ein zweites Paar (22) umfasst, das zwei weitere flexible Lamellen (33, 34) aufweist, die jeweils einerseits ein Primärlager (43, 44) des ersten Elements (4) oder ein Sekundärlager (53, 54) des zweiten Elements (5) mit einem Tertiärlager (63, 64) andererseits verbinden, das ein drittes Element (6) aufweist, das so angeordnet ist, dass es an einer festen Struktur des Resonators (100) befestigbar ist.

6. Drehzapfen (1) nach den Ansprüchen 4 und 5, **dadurch gekennzeichnet, dass** das erste Element (4) oder das zweite Element (5) ein Trägheitselement ist und dass sich die theoretische Schwenkachse (A) geometrisch in dem Auge (40, 50) befindet, das das Trägheitselement umfasst.

7. Drehzapfen (1) nach einem der Ansprüche 1 bis 6, **dadurch gekennzeichnet, dass** das erste Element (4) oder das zweite Element (5) eine konkave Oberfläche (74) aufweist, die so angeordnet ist, dass sie eine konvexe Oberfläche (75), die das zweite Element (5) bzw. das erste Element (4) aufweist, in einem Abstand von mindestens 180° umgibt, wobei in einer Ruheposition des Drehzapfens (1) ein Spiel an jedem Punkt größer oder gleich einem Sicherheitsspiel (J) zwischen der konvexen Oberfläche (75) und der konkaven Oberfläche (74) ist.

8. Drehzapfen (1) nach Anspruch 5 und einem der Ansprüche 1 bis 7, **dadurch gekennzeichnet, dass** das erste Element (4) oder das zweite Element (5) ein Trägheitselement ist und dass das dritte Element (6) eine Innenfläche (76) aufweist, die so angeordnet ist, dass sie eine konvexe Oberfläche (75), die das Trägheitselement aufweist, in einem Abstand von mindestens 180° umgibt, wobei in einer Ruheposition des Drehzapfens (1) ein Spiel an jedem Punkt größer oder gleich einem Sicherheitsspiel (J) zwischen der konvexen Oberfläche (75) und der Innenfläche (76) ist.

9. Drehzapfen (1) nach Anspruch 5 oder nach einem der davon abhängigen Ansprüche, **dadurch gekennzeichnet, dass** einerseits die primären Lager (43, 44) des ersten Elements (4) oder sekundären Lager (53, 54) des zweiten Elements (5) und andererseits die tertiären Lager (63, 64), die zwei Sekundärrichtungen (DL3, DL4) der Lamellen definieren, zusammen einen zweiten Scheitelwinkel (β) an einer Sekundärachse (B) bilden, die durch den Schnittpunkt in der Ebene oder in der Projektion der Sekundärrichtung (DL3, DL4) der Lamellen definiert ist, wobei der zweite Scheitelwinkel (β) zwischen 115° und 130°, Grenzwerte eingeschlossen, liegt und wobei der Wert in Grad die folgende Beziehung erfüllt: f1 (D/L) < β < f2(D/L), mit fi(X) = 108 + 67/(10X - 6), und f₂(X) = 113 + 67/(10X -6), mit X = D/L.

10. Drehzapfen (1) nach den Ansprüchen 2 und 9, **dadurch gekennzeichnet, dass** eine Medianfunktion fm(X) = 110,5 + 67/(10X - 6) ein Zwischenverhältnis zwischen der ersten unteren Funktion f₁(X) = 108 + 67/(10X - 6) und der ersten oberen Funktion f₂(X) = 113 + 67/(10X - 6), mit X = D/L, definiert und dass der erste Scheitelwinkel (α) und der zweite Scheitelwinkel (β) zwischen der ersten unteren Funktion (f1) und der ersten oberen Funktion f2 beiderseits der Medianfunktion fm positioniert sind.

11. Drehzapfen (1) nach Anspruch 9 oder 10, **dadurch gekennzeichnet, dass** die theoretische Schwenkachse (A) und die Sekundärachse (B) zusammenfallen.

12. Drehzapfen (1) nach einem der Ansprüche 1 bis 11, **dadurch gekennzeichnet, dass** der Drehzapfen (1) mindestens ein Paar (2, 21, 22) umfasst, das zwei flexible Lamellen (31, 32) aufweist, die entweder in Bezug auf eine Symmetrieebene, die durch die theoretische Schwenkachse (A) verläuft, symmetrisch sind, wenn diese beiden flexiblen Lamellen (31, 32) koplanar sind, oder in einer Projektion auf eine zu den beiden flexiblen Lamellen (31, 32) parallele Bezugsebene in Bezug auf eine Symmetrieebene, die durch die theoretische Schwenkachse (A) verläuft, symmetrisch sind, wenn sich die beiden flexiblen Lamellen (31, 32) in zwei zu der Bezugsebene parallelen Ebenen, die jedoch nicht koplanar sind, erstrecken.

13. Drehzapfen (1) nach Anspruch 12, **dadurch gekennzeichnet, dass** jedes Paar (2, 21, 22), das der Drehzapfen (1) umfasst, zwei flexible Lamellen (31, 32) aufweist, die entweder in Bezug auf eine Ebene, die durch die theoretische Schwenkachse (A) verläuft, symmetrisch identisch sind, wenn die beiden flexiblen Lamellen (31, 32) koplanar sind, oder in der Projektion auf eine zu den beiden flexiblen Lamellen (31, 32) parallele Bezugsebene symmetrisch identisch sind, wenn sich die beiden flexiblen Lamellen (31, 32) in zwei zu der Bezugsebene parallelen Ebenen, die jedoch nicht koplanar sind, erstrecken.

14. Drehzapfen (1) nach einem der Ansprüche 1 bis 13, **dadurch gekennzeichnet, dass** der Drehzapfen (1) mindestens ein Paar (2, 21, 22) aufweist, das zwei flexible Lamellen (31, 32) aufweist, die koplanar sind.

15. Resonator (100), umfassend ein erstes Element (4) und ein zweites Element (5), die durch mindestens ein Paar (2, 21, 22) verbunden sind, das zwei flexible Lamellen (31, 32) aufweist, die ein Drehzapfen (1) nach einem der Ansprüche 1 bis 14 umfasst, **dadurch gekennzeichnet, dass** der Massenschwerpunkt des Resonators (100) in seiner Ruheposition von der theoretischen Schwenkachse (A) um einen Abstand (ε), der zwischen dem 0,8-fachen und dem 1,2-fachen Wert von (2D²/L-1,6D - 0,1L) liegt, entfernt ist.

16. Resonator (100) nach Anspruch 15, **dadurch gekennzeichnet, dass** der Drehzapfen (1) zumindest in einer Projektion auf die Bezugsebene in Bezug auf eine Symmetrieebene, die durch die theoretische Schwenkachse (A) verläuft, symmetrisch ist und dass sich der Massenschwerpunkt des Resonators (100) in seiner Ruheposition geometrisch in der Symmetrieebene befindet.

17. Uhrwerk (1000), umfassend einen Resonator (100) nach Anspruch 15 oder 16.

18. Uhr (2000), umfassend ein Uhrwerk (1000) nach Anspruch 17.

## Claims

1. Isochronous pivot (1) for a timepiece resonator (100), with a flexure bearing, comprising at least one pair (2, 21, 22) including two flexible strips (31, 32) each joining a first point of attachment (41, 42) of a first element (4) to a second point of attachment (51, 52) of a second element (5), said first attachment points (41, 42) defining, with said respective second attachment points (51, 52), two main strip directions (DL1, DL2), said first element (4) and said second element (5) each being stiffer than each of said flexible strips (3), and each able to form a movable inertial element inside a said resonator (100), and said two main strip directions (DL1, DL2) defining a theoretical pivot axis (A), at their crossing point, or at the crossing point of their projections onto a reference plane parallel to said two flexible strips (31, 32), , each said flexible strip (31, 32) having a free length (L1, L2) between its two attachment points (41, 51, 42, 52), and having an axial distance (D1, D2) between said theoretical pivot axis (A) and whichever of its two attachment points (41, 51, 42, 52) is farthest therefrom, and wherein, for each said flexible strip (31, 32), the main attachment point ratio (D1/L1, D2/L2) between said axial distance and said free length is greater than one,wherein said two main strip directions (DL1 , DL2) define with said theoretical pivot axis (A) a first apex angle (α) whose value in degrees satisfies the relation f1(D/L)<α<f2(D/L), with f1(X) = 108 + 67/(10X-6), and f2(X) = 113 + 67/(10X-6), with X = D/L, **characterized in that** said pivot (1) includes at least one pair (2, 21, 22) including two flexible strips (31, 32), which extend on two levels parallel to said reference plane but are not coplanar.

2. Pivot (1) according to claim 1, **characterized in that** said two main strip directions (DL1, DL2) define with said theoretical pivot axis (A) a first apex angle (α) comprised between 115° and 130° inclusive.

3. Pivot (1) according to claim 1 or 2, **characterized in that** said theoretical pivot axis (A) is geometrically located in said first element (4) or in said second element (5).

4. Pivot (1) according to claim 3, **characterized in that** said theoretical pivot axis (A) is geometrically located in an eye (40, 50) comprised in said first element (4) or said second element (5).

5. Pivot (1) according to any one of claims 1 to 4, **characterized in that** said pivot (1) includes, in addition to a first pair (21) including said two flexible strips (31, 32) each joining a first attachment point (41, 42) of a first element (4) to a second attachment point (51, 52) of a second element (5), at least a second pair (22) including two other flexible strips (33, 34) each joining, on the one hand, a primary attachment point (43, 44) of said first element (4) or a secondary attachment point (53, 54) of said second element (5), to, on the other hand, a third attachment point (63, 64) comprised in a third element (6) arranged to be fixedly secured to a fixed structure of said resonator (100).

6. Pivot (1) according to claims 4 and 5, **characterized in that** said first element (4) or said second element (5) is an inertial element, and **in that** said theoretical pivot axis (A) is geometrically located in said eye (40, 50) comprised in said inertial element.

7. Pivot (1) according to any one of claims 1 to 6, **characterized in that** said first element (4) or said second element (5) includes a concave surface (74) arranged to surround at a distance, over at least 180°, a convex surface (75) comprised in said second element (5) or said first element (4) respectively, with, in a rest position of said pivot (1), a clearance which, at every point, is greater than or equal to a safety clearance (J) between said convex surface (75) and said concave surface (74).

8. Pivot (1) according to claim 5 and any one of claims 1 to 7, **characterized in that** said first element (4) or said second element (5) is an inertial element, and **in that** said third element (6) includes an internal surface (76) arranged to surround at a distance, over at least 180°, a convex surface (75) comprised in said inertial element, with, in a rest position of said pivot (1), a clearance which, at every point, is greater than or equal to a safety clearance (J) between said convex surface (75) and said internal surface (76).

9. Pivot (1) according to claim 5 or any one of the dependent claims, **characterized in that** said primary attachment points (43, 44) of said first element (4) or secondary elements (53, 54) of said second element (5) on the one hand, and said tertiary attachment points (63, 64) on the other hand, define two secondary strip directions (DL3, DL4) together forming a second apex angle (β) at a secondary axis (B) defined by the intersection, in plane or in projection, of said secondary strip directions (DL3, DL4), said second apex angle (β) being comprised between 115° and 130° inclusive, and whose value in degrees satisfies the relation f1(D/L) <β<f2(D/L), with f1(X) = 108 + 67/(10X-6), and f2(X) = 113 + 67/(10X-6), with X = D/L.

10. Pivot (1) according to claims 2 and 9, **characterized in that** a median function fm(X) = 110.5 + 67/(10X-6) defines an intermediate ratio between the first lower function f1(X) = 108 + 67/(10X-6), and the first upper function f2(X) = 113 + 67/(10X-6), with X = D/L, and **in that** said first apex angle (α) and said second apex angle (β) are positioned between said first lower function f1 and said first upper function f2, on either side of said median function fm.

11. Pivot (1) according to claim 9 or 10, **characterized in that** said theoretical pivot axis (A) and secondary axis (B) are coincident.

12. Pivot (1) according to any one of claims 1 to 11, **characterized in that** said pivot (1) includes at least one pair (2, 21, 22) including two flexible strips (31, 32), which are either symmetrical with respect to a plane of symmetry passing through said theoretical pivot axis (A) when said two flexible strips (31, 32) are coplanar, or symmetrical in projection onto a reference plane parallel to said two flexible strips (31, 32) when said two flexible strips (31, 32) extend on two levels parallel to said reference plane but are not coplanar, with respect to a plane of symmetry passing through said theoretical pivot axis (A).

13. Pivot (1) according to claim 12, **characterized in that** each said pair (2, 21, 22) comprised in said pivot (1), includes two flexible strips (31, 32), which are either identical in symmetry with respect to a plane passing through said theoretical pivot axis (A) when said two flexible strips (31, 32) are coplanar, or identical in symmetry in projection onto a reference plane parallel to said two flexible strips (31, 32) when said two flexible strips (31, 32) extend on two levels parallel to said reference plane but are not coplanar.

14. Pivot (1) according to any one of claims 1 to 13, **characterized in that** said pivot (1) also includes at least one pair (2, 21, 22) including two flexible strips (31, 32) which are coplanar.

15. Resonator (100) including a first element (4) and a second element (5), joined by at least one pair (2, 21, 22) including two flexible strips (31, 32) comprised in a pivot (1) according to any one of claims 1 to 14, **characterized in that** the centre of mass of said resonator (100) in its rest position is separated from said theoretical pivot axis (A) by a distance (ε) which is comprised between 0.8 times and 1.2 times the value (2D²/L - 1.6. D - 0.1 L).

16. Resonator (100) according to claim 15, **characterized in that** said pivot (1) is symmetrical, at least in projection onto said reference plane, with respect to a plane of symmetry passing through said theoretical pivot axis (A), and **in that** the centre of mass of said resonator (100) in its rest position is geometrically located on said plane of symmetry.

17. Timepiece movement (1000) including at least one resonator (100) according to claim 15 or 16.

18. Watch (2000) including a timepiece movement (1000) according to claim 17.
